# FASCICULE DE BREVET EUROPEEN

(11) **EP 2 533 620 B1**
(45) Date de publication et mention de la délivrance du brevet: **14.05.2014**
(21) Numéro de dépôt: 12170989.3
(22) Date de dépôt: 06.06.2012
(51) Int. Cl.: H05K 5/06, H02M 7/00

(54) **Dispositif de conversion d'énergie électrique comprenant un module de puissance, une enceinte étanche et des organes de maintien du module dans l'enceinte, avec seulement deux organes de maintien dans un même plan transversal**
Vorrichtung zur Umwandlung von elektrischer Energie, die ein Leistungsmodul, einen dichten Behälter und Organe zur Befestigung des Moduls im Behälter umfasst, mit nur zwei auf derselben Querebene angeordneten Befestigungsoganen
Electric power conversion device comprising a power module, a sealed enclosure and members for holding the module inside the enclosure, with only two holding members in a single transverse plane

(30) Priorité: 07.06.2011 FR 1154941
(43) Date de publication de la demande: 12.12.2012
(73) Titulaire: GE Energy Power Conversion Technology Limited, Rugby Warwickshire CV21 1BU (GB)
(72) Inventeur: Baerd, Henri, 77430 Champagne sur Seine (FR); Renaud, Guillaume, 91300 Massy (FR)
(74) Mandataire: Serjeants LLP

(56) Documents cités:
- EP-A1- 1 310 759
- EP-A1- 2 234 468
- FR-A1- 2 711 300
- US-A1- 2010 208 446

## Description

La présente invention concerne un dispositif de conversion d'énergie électrique pour un système d'entraînement électrique de station sous-marine de compression et de pompage, du type comprenant:
- un module électrique de puissance, le module électrique de puissance comportant au moins une poutre,
- une enceinte étanche de logement du module de puissance, l'enceinte étanche s'étendant selon une direction longitudinale ; et
- une pluralité d'organes de maintien du module électrique à l'intérieur de l'enceinte étanche, chaque organe de maintien comportant au moins une liaison mécanique, la ou chaque liaison mécanique d'un organe de maintien respectif étant reliée à une unique poutre du module de puissance.

La présente invention s'applique notamment à un dispositif de conversion d'énergie électrique propre à être immergé à une profondeur supérieure à 50m.

On connaît un dispositif de conversion du type précité. L'enceinte étanche comporte trois tronçons successifs suivant la direction longitudinale, et mobiles entre une position de fermeture de l'enceinte dans laquelle les tronçons sont fixés les uns aux autres et une position d'ouverture de l'enceinte dans laquelle les tronçons sont à l'écart les uns des autres. Les trois tronçons sont un tronçon intermédiaire et deux tronçons d'extrémité disposés de part et d'autre du tronçon intermédiaire. Le module électrique de puissance comporte une ossature mécanique à laquelle sont fixés les différents équipements électriques de puissance. L'ossature mécanique s'étend selon la direction longitudinale, et comporte des longerons sensiblement longitudinaux et des traverses reliant les longerons entre eux. L'ossature mécanique présente une section hexagonale suivant un plan transversal perpendiculaire à la direction longitudinale. Le module électrique de puissance est maintenu par l'intermédiaire de ses longerons au tronçon intermédiaire de l'enceinte étanche, en chacun des six sommets de la section hexagonale et en chacune de ses deux extrémités longitudinales.

US2010208446 A1 décrit un convertisseur électronique de puissance qui comporte au moins un banc de condensateur continu et un onduleur de tension. L'onduleur de tension est intégré dans une structure de support en treillis, de forme extérieure hexagonale, et recouverte par une enveloppe étanche formant une enceinte étanche supportant la pression marine à la profondeur d'utilisation.

EP2234468 A1 décrit un module électrique qui électrique comprend une enceinte étanche, au moins un équipement électrique disposé dans l'enceinte étanche et qui, en fonctionnement, chauffe l'atmosphère, et un circuit de refroidissement secondaire. Le circuit secondaire comprend un conduit de guidage disposé dans l'enceinte étanche de manière à guider l'atmosphère qui a été chauffée par le ou les équipements électriques vers son ouverture supérieure, et un passage pour l'atmosphère délimité au moins en partie par l'enceinte étanche afin de permettre un refroidissement de l'atmosphère au contact de l'enceinte étanche.

Toutefois, les équipements électriques de puissance doivent être proches les uns des autres, afin de limiter l'encombrement du module de puissance, et a fortiori celui du dispositif de conversion, l'encombrement du dispositif de conversion étant malgré tout important. En outre, la proximité entre les différents équipements électriques de puissance limite l'accessibilité auxdits équipements de puissance.

Le but de l'invention est donc de proposer un dispositif de conversion d'énergie électrique présentant un encombrement plus faible, tout en offrant une meilleure accessibilité aux équipements électriques du module de puissance.

A cet effet, l'invention a pour objet un dispositif de conversion du type précité, **caractérisé en ce que** le nombre P d'organe(s) de maintien disposé(s) sensiblement dans un même plan transversal, perpendiculaire à la direction longitudinale, est un nombre entier inférieur ou égal à 2.

Suivant d'autres modes de réalisation, le dispositif de conversion comprend une ou plusieurs des caractéristiques suivantes, prises isolément ou selon toutes les combinaisons techniquement possibles :
- le nombre P est égal à 2,
- les organes de maintien disposés dans un même plan transversal sont diamétralement opposés par rapport à un axe médian du module, l'axe médian étant parallèle à la direction longitudinale,
- les organes de maintien sont disposés en N positions longitudinales successives selon la direction longitudinale, N étant un nombre entier supérieur ou égal à 2, de préférence supérieur ou égal à 3, de préférence encore supérieur ou égal à 5,
- le module électrique de puissance comprend une ossature mécanique comportant deux longerons sensiblement longitudinaux, et au moins deux traverses, chaque traverse reliant mécaniquement les deux longerons,
- chaque organe de maintien est solidaire d'un longeron respectif,
- le module électrique de puissance comprend en outre au moins un plateau transversal agencé perpendiculairement aux longerons, le ou chaque plateau transversal étant solidaire des deux longerons,
- les organes de maintien sont fixés au voisinage de chacune des extrémités des longerons et également en regard d'au moins un plateau transversal disposé à l'écart des extrémités des longerons,
- l'enceinte étanche comporte au moins deux tronçons successifs suivant la direction longitudinale, et le ou les organe(s) de maintien disposé(s) en l'une des deux positions longitudinales extrêmes comporte(nt) des moyens de suspension à un tronçon correspondant,
- le ou les organe(s) de maintien disposé(s) en une position longitudinale autre que ladite position longitudinale extrême comporte(nt) des moyens d'appui contre l'enceinte ; et
- les moyens d'appui correspondant à un organe de maintien respectif comportent deux ressorts, chaque ressort présentant une direction de travail selon laquelle la force du ressort est supérieure à celle selon les autres directions, et les directions de travail des deux ressorts sont perpendiculaires.

Ces caractéristiques et avantages de l'invention apparaîtront à la lecture de la description qui va suivre, donnée uniquement à titre d'exemple, et faite en référence aux dessins annexés, sur lesquels :
- la figure 1 est une vue de face d'un dispositif de conversion selon l'invention, comprenant un module électrique de puissance et une enceinte étanche de logement du module de puissance,
- la figure 2 est une vue en coupe suivant le plan II de la figure 1,
- la figure 3 est une vue en coupe suivant le plan III de la figure 2, et
- la figure 4 est une vue en perspective d'une ossature mécanique du module de puissance de la figure 1.

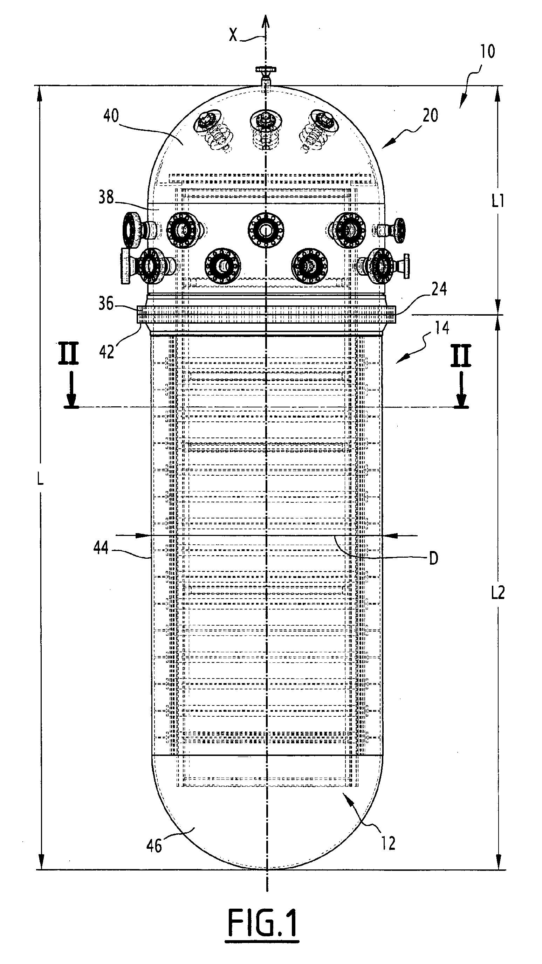

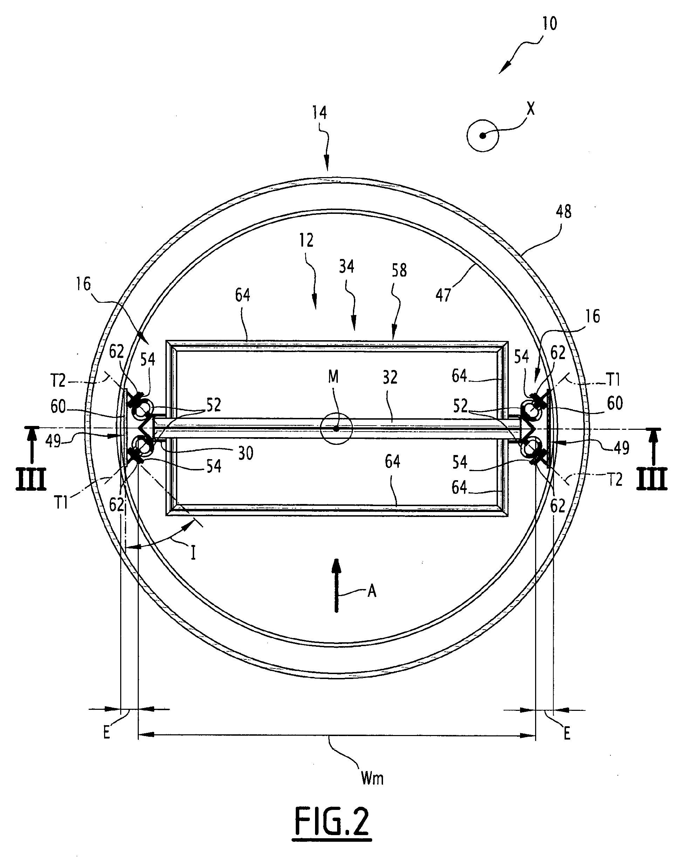

Sur les figures 1 et 2, un dispositif 10 de conversion d'énergie électrique comprend un module électrique de puissance 12, une enceinte étanche 14 de logement du module de puissance, l'enceinte étanche 14 s'étendant selon une direction longitudinale X, et une pluralité d'organes 16 de maintien du module électrique à l'intérieur de l'enceinte étanche.

Le dispositif de conversion 10 est propre à alimenter un système, non représenté, d'entraînement électrique de station sous-marine de compression et de pompage.

Le dispositif de conversion 10 est destiné à être immergé à une profondeur supérieure à 50m, par exemple comprise entre 1000m et 3000m. Le dispositif de conversion 10 résiste donc à une pression extérieure supérieure à 6 bars, par exemple comprise entre 100 bars et 300 bars.

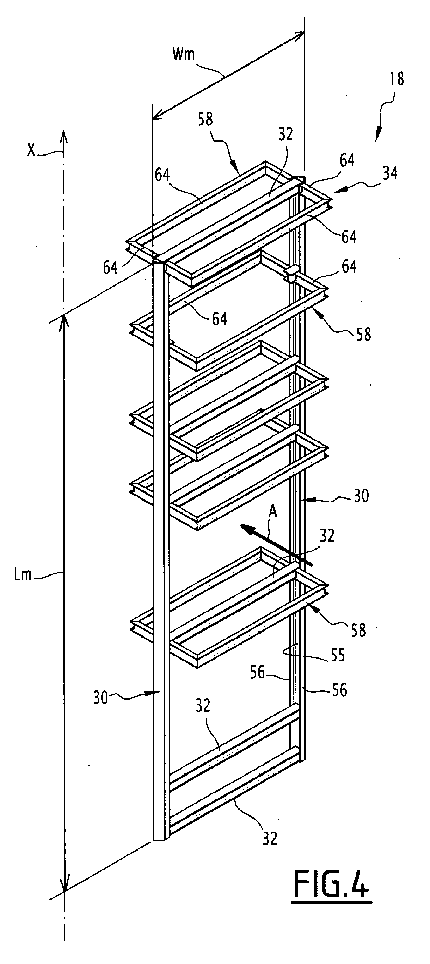

Le module électrique de puissance 12 comporte une ossature mécanique 18, représentée sur la figure 1 en pointillés et visible sur la figure 4, et des équipements électriques de puissance, non représentés, solidaires de l'ossature mécanique 18.

Le module de puissance 12 présente une longueur Lm selon la direction longitudinale X, comme représenté sur la figure 4. La longueur Lm est, par exemple, supérieure ou égale à 2m, de préférence supérieure ou égale à 5m.

Le module électrique de puissance 12 présente une puissance électrique élevée, par exemple, supérieure à 100 kW, de préférence supérieure à 1 MW.

L'enceinte étanche 14 est au moins partiellement en forme d'un cylindre, et présente un diamètre D de valeur comprise entre 1 et 3m, comme représenté sur la figure 1. L'enceinte étanche 14 présente une longueur L selon la direction longitudinale X, par exemple de l'ordre de 10m.

L'enceinte étanche 14 comporte au moins deux tronçons 20, 22 successifs suivant la direction longitudinale X, et mobiles entre une position de fermeture de l'enceinte 14 dans laquelle les tronçons 20, 22 sont fixés les uns aux autres (figure 1) et une position d'ouverture de l'enceinte 14 dans laquelle les tronçons 20, 22 sont à l'écart les uns des autres.

Dans l'exemple de réalisation de la figure 1, l'enceinte 14 comporte un premier tronçon 20, également appelé tronçon d'extrémité, et un second tronçon 22, également appelé tronçon principal, et un joint d'étanchéité 24 agencé entre les deux tronçons 20, 22.

Le nombre P d'organes de maintien 16 disposés sensiblement dans un même plan transversal, perpendiculaire à la direction longitudinale X est un nombre entier inférieur ou égal à 2, comme représenté sur la figure 2.

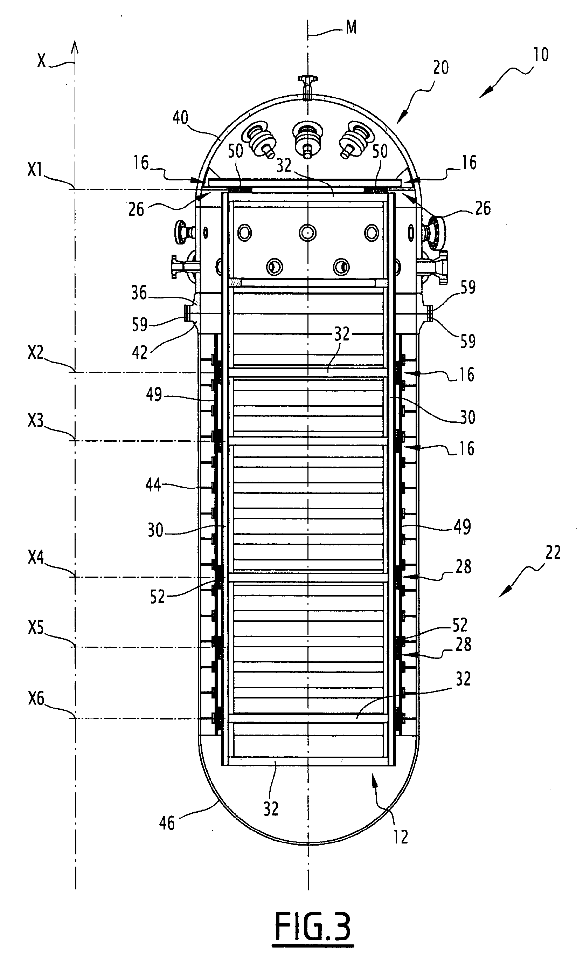

Dans l'exemple de réalisation de la figure 2, le nombre P est égal à 2. Les organes de maintien 16 disposés dans un même plan transversal sont diamétralement opposés par rapport à un axe médian M du module de puissance 12, l'axe médian M étant parallèle à la direction longitudinale X, comme représenté sur les figures 2 et 3.

Les organes de maintien 16 sont disposés en N positions longitudinales X1, X2, X3, X4, X5, X6 successives selon la direction longitudinale X, comme représenté sur la figure 3. Les positions longitudinales sont également notées Xi, i représentant l'indice de la position longitudinale, compris entre 1 et N. Le nombre N de position longitudinale Xi est un nombre entier, de préférence supérieur ou égal à 3, de préférence encore supérieur ou égal à 5. Dans l'exemple de réalisation de la figure 3, le nombre N est égal à 6.

La distance maximale entre deux positions longitudinales successives Xi, X(i+1) est inférieure à 2,5m.

Le ou les organes de maintien 16 disposés sensiblement dans un même plan transversal présentent une même position longitudinale Xi.

Le ou les organes de maintien 16 disposés en la position longitudinale extrême X1 comportent des moyens 26 de suspension du module de puissance au premier tronçon 20.

Le ou les organes de maintien 16 disposés en des positions longitudinales X2 à X6 autres que ladite position longitudinale extrême X1 comportent des moyens 28 d'appui contre l'enceinte 14.

L'ossature mécanique 18, visible sur les figures 2 et 4, comprend deux poutres 30 sensiblement longitudinales, également appelées longerons, et au moins deux poutres transversales 32, sensiblement perpendiculaires aux poutres longitudinales 30, chaque poutre transversale 32, également appelée traverse, reliant mécaniquement les deux longerons 30.

En complément, l'ossature mécanique 18 comprend au moins un plateau transversal 34 agencé perpendiculairement aux longerons 30, le ou chaque plateau transversal 34 étant solidaire des deux longerons 30. Dans l'exemple de réalisation de la figure 4, l'ossature mécanique 18 comprend cinq plateaux transversaux 34.

L'ossature mécanique 18 du module de puissance est solidaire du premier tronçon 20. L'ossature mécanique 18 est reliée à l'intérieur du premier tronçon 20 par l'intermédiaire des moyens de suspension 26.

L'ossature mécanique 18 présente une masse inférieure à 5 tonnes, de préférence inférieure à 3 tonnes. Dans l'exemple de réalisation de la figure 4, la masse de l'ossature mécanique 18 est égale à 2,5 tonnes.

L'ossature mécanique 18 est, par exemple, réalisée en acier, en acier inoxydable, en aluminium, ou encore en matériau composite, tel que le carbone ou la fibre de verre.

Chaque organe de maintien 16 comporte au moins une liaison mécanique, la ou chaque liaison mécanique d'un organe de maintien 16 respectif étant reliée à une unique poutre 30, 32 du module de puissance 12.

Dans l'exemple de réalisation des figures 1 à 3, chaque organe de maintien 16 est solidaire d'un longeron 30 respectif.

Les organes de maintien 16 sont disposés au voisinage de chacune des extrémités des longerons 30, par exemple à une distance inférieure à un mètre desdites extrémités, les positions longitudinales extrêmes correspondantes étant les positions X1 et X6. Les organes de maintien 16 sont également disposés au regard d'au moins un plateau transversal 34 disposé à l'écart des extrémités des longerons 30.

Dans l'exemple de réalisation de la figure 3, les organes de maintien 16 sont disposés en regard d'une pluralité de plateaux transversaux 34 disposés à l'écart des extrémités des longerons 30, en les positions longitudinales X2, X3 et X4.

En variante, au moins un organe de maintien 16 est solidaire d'une traverse 32 respective.

Le premier tronçon 20, visible sur les figures 1 et 3, comprend une première bride 36 de fixation du premier tronçon au deuxième tronçon, une partie cylindrique 38 fixée à la première bride, et un dôme 40 fixé à la partie cylindrique. Le premier tronçon 20 est ouvert à son extrémité longitudinale du côté de la première bride 36, et fermé à son autre extrémité longitudinale par le dôme 40.

Le premier tronçon 20 présente une première longueur L1 selon la direction longitudinale X. La première longueur L1 est inférieure à la moitié de la longueur L de l'enceinte selon la direction longitudinale X.

Dans l'exemple de réalisation de la figure 1, la première longueur L1 est inférieure à 0,3 fois la longueur L de l'enceinte, par exemple égale à 0,25 fois la longueur L de l'enceinte. En variante, la première longueur L1 est inférieure à 0,2 fois la longueur L de l'enceinte, de préférence encore inférieure à 0,1 fois la longueur L de l'enceinte.

Le premier tronçon 20 est, par exemple, réalisé en acier, en titane, en une composition hybride d'acier et de béton, ou encore en une composition hybride d'acier et d'un matériau composite, tel que le carbone ou la fibre de verre.

Le deuxième tronçon 22, visible sur les figures 1 et 3, comporte une deuxième bride 42 de fixation du deuxième tronçon au premier tronçon, une partie cylindrique 44 fixée à la deuxième bride, et un dôme 46 fixé à la partie cylindrique.

Le deuxième tronçon 22 comporte une face interne 47, et une face externe 48 orientée vers l'extérieur et destinée à être en contact avec l'eau.

Le deuxième tronçon 22 comporte deux glissières 49 fixées à la face interne 47 de manière diamétralement opposée par rapport à l'axe médian M du module, comme représenté sur la figure 3.

Le deuxième tronçon 22 est ouvert à son extrémité longitudinale du côté de la deuxième bride de fixation, et fermé à son autre extrémité longitudinale par le dôme 46.

L'espacement E entre la face interne 47 et le longeron 30 correspondant lorsque le module de puissance 12 est maintenu dans l'enceinte 14 est inférieur à 0,05 fois le diamètre D de l'enceinte, de préférence égal à 0,04 fois le diamètre D.

Le deuxième tronçon 22 présente une deuxième longueur L2 selon la direction longitudinale X. La deuxième longueur L2 est strictement supérieure à la première longueur L1.

Dans l'exemple de réalisation de la figure 1, la deuxième longueur L2 est supérieure à 0,7 fois la longueur L de l'enceinte selon la direction longitudinale X, par exemple égale à 0,75 fois la longueur L de l'enceinte. En variante, la deuxième longueur L2 est supérieure à 0,8 fois la longueur L de l'enceinte, de préférence encore supérieure à 0,9 fois la longueur L de l'enceinte.

Le deuxième tronçon 22 est, par exemple, réalisé en acier, en titane, en une composition hybride d'acier et de béton, ou encore en une composition hybride d'acier et d'un matériau composite, tel que le carbone ou la fibre de verre.

La somme de la première longueur L1 et de la deuxième longueur L2 est égale à la longueur L de l'enceinte.

Le joint d'étanchéité 24 est agencé entre les deux brides de fixation 36, 42. Le joint d'étanchéité 24 est, par exemple, un joint plat.

Les moyens de suspension 26 correspondant à une paire d'organes de maintien 16 agencés en la position longitudinale extrême X1 sont diamétralement opposés par rapport à l'axe médian M, comme représenté sur la figure 3.

Les moyens de suspension 26 sont, par exemple, des moyens élastiques. Dans l'exemple de réalisation de la figure 3, les moyens de suspension 26 correspondant à chaque organe de maintien 16 comportent un ressort 50.

Chaque organe de maintien 16 disposé en la position longitudinale extrême X1 comporte une seule liaison mécanique, par exemple celle formée par le ressort 50.

Les moyens d'appui 28 sont solidaires d'un longeron 30 correspondant et sont répartis successivement le long dudit longeron 30 selon la direction longitudinale X.

Les moyens d'appui 28 sont, par exemple, des moyens élastiques. Dans l'exemple de réalisation de la figure 2, les moyens d'appui 28 comportent une pluralité de paires de ressorts 52 équipés chacun d'une platine d'appui 54.

Chaque organe de maintien 16 disposé en une position longitudinale Xi autre que ladite position longitudinale extrême X1 comporte deux liaisons mécaniques, par exemple les deux liaisons mécaniques formées par les deux ressorts 52 d'une paire de ressorts.

En complément, les moyens d'appui 28 de la ou chaque paire d'organes de maintien 16 correspondant à une même position longitudinale X2 à X6 autre que la position longitudinale extrême X1 sont diamétralement opposés par rapport à l'axe médian M du module 12.

Les poutres 30, 32 forment un cadre disposé dans un plan médian de l'enceinte étanche 14. Le cadre formé par les poutres 30, 32 présente la longueur Lm selon la direction longitudinale X et une largeur Wm selon une direction perpendiculaire à la direction longitudinale X, comme représenté sur la figure 4. La largeur Wm est supérieure ou égale à 0,75 fois le diamètre D de l'enceinte, de préférence égale à 0,8 fois le diamètre D de l'enceinte.

Les poutres 30, 32 de l'ossature mécanique du module 12 présentent une masse linéique de valeur inférieure à 100 kg/m, de préférence inférieure à 80 kg/m, de préférence encore inférieure à 60 kg/m.

Chaque poutre 30, 32 est, par exemple, réalisée en acier, en acier inoxydable, en aluminium, ou encore en matériau composite, tel que le carbone ou la fibre de verre.

Chaque longeron 30 présente une section en forme de U, et comporte une âme longitudinale 55 et deux ailes 56 fixées chacune à un bord longitudinal de l'âme 55, comme représenté sur la figure 4.

Chaque traverse 32 présente une section en forme de H. Les extrémités des traverses 32 sont chacune insérées entre les deux ailes 56 du longeron correspondant.

Chaque plateau transversal 34, visible sur la figure 2, comporte un cadre 58 fixé aux longerons 30.

En complément, chaque plateau transversal 34 comporte la traverse 32 solidaire du cadre, la traverse 32 étant fixée en chacune de ses extrémités à un longeron 30 correspondant.

La première bride de fixation 36 est fixée à la deuxième bride de fixation 42 en position de fermeture de l'enceinte. Dans l'exemple de réalisation de la figure 3, la première bride de fixation 36 comporte une pluralité de trous traversants longitudinaux 59 destinés à recevoir des moyens de fixation, non représentés, de la première bride 36 à la deuxième bride 42.

Le dôme 40 est, par exemple, en forme d'une demi-sphère. En variante, le dôme 40 est en forme d'un demi-ellipsoïde.

La deuxième bride de fixation 42, visible sur la figure 3, est fixée à la première bride en position de fermeture de l'enceinte, et comporte une pluralité de trous traversants longitudinaux 59 destinés à recevoir les moyens de fixation, non représentés, de la première bride 36 avec la deuxième bride 42.

Le dôme 46 est, par exemple, en forme d'une demi-sphère. En variante, le dôme 46 est en forme d'un demi-ellipsoïde.

Chaque glissière 49, visible sur la figure 2, comporte une âme 60 et deux plans inclinés 62, l'âme 60 et les plans inclinés 62 s'étendant principalement selon la direction longitudinale X.

Les glissières 49 forment avec les moyens d'appui 28 des moyens complémentaires de coulissement le long de la direction longitudinale X.

Le premier ressort 52 de la paire de ressorts présente une première direction de travail T1, et le deuxième ressort 52 de la paire présente une deuxième direction de travail T2, la direction de travail T1, T2 de chaque ressort 52 étant la direction selon laquelle la force du ressort est supérieure à la force du ressort selon les autres directions. La première direction de travail T1 du premier ressort est perpendiculaire à la deuxième direction de travail T2 du deuxième ressort.

Chaque ressort 52 est fixé entre le longeron 30 et la platine d'appui 54 correspondants.

Chaque platine d'appui 54 est propre à glisser le long de la glissière 49 correspondante selon la direction longitudinale X, et les moyens d'appui 28 sont alors des moyens d'appui glissant.

Le cadre 58 de chaque plateau transversal 34 comporte une pluralité de poutres 64, chaque poutre 64 correspondant à un côté du cadre, comme représenté sur la figure 4.

En variante de l'exemple de réalisation des figures 1 à 3 où chaque organe de maintien 16 est solidaire d'un longeron 30 respectif, au moins un organe de maintien 16 est solidaire d'une poutre 64 respective.

Les plans inclinés 62 forment avec l'âme 60 un angle d'inclinaison I, visible sur la figure 2, sensiblement égal à 45 degrés. Les plans inclinés 62 d'une même glissière sont orientés de telle sorte qu'ils sont perpendiculaires l'un à l'autre, et sont propres à coopérer avec les platines d'appui 54 fixées à une paire de ressorts 52 respective.

Ainsi, le dispositif de conversion 10 selon l'invention permet de réduire l'encombrement des organes de maintien 16, ceux-ci étant disposés sensiblement dans le plan du cadre formé par les longerons 30 et les traverses 32 de l'ossature mécanique du module de puissance. L'espacement E entre un longeron 30 respectif et la face interne 47 du deuxième tronçon de l'enceinte présente alors une valeur réduite, inférieure à 5% du diamètre D de l'enceinte.

En outre, l'agencement particulier des ressorts 52 des moyens d'appui 28 avec la première direction de travail T1 perpendiculaire à la deuxième direction de travail T2 permet de mieux amortir les mouvements éventuels entre le module de puissance 12 et l'enceinte étanche 14, puisque les efforts sont récupérés selon deux directions perpendiculaires, au lieu d'être récupérés suivant une unique direction radiale selon l'agencement des liaisons mécaniques entre le module de puissance et l'enceinte du dispositif de conversion de l'état de la technique.

La présence d'au plus deux organes de maintien 16 dans un même plan transversal perpendiculaire à la direction longitudinale X permet en outre de faciliter l'accès aux équipements électriques de puissance, notamment suivant la flèche A visible sur les figures 2 et 4, les équipements électriques étant fixés aux différents plateaux 34.

La présence d'au plus deux organes de maintien 16 dans un même plan transversal permet également de disposer d'un volume utile plus important à l'intérieur de l'enceinte 14 pour l'agencement des équipements électriques du module de puissance 12.

La diminution de l'encombrement des organes de maintien 16 permet de diminuer l'encombrement du dispositif de conversion 10 selon l'invention par rapport au dispositif de conversion de l'état de la technique pour un module électrique de puissance de même volume.

A titre d'exemple, l'enceinte étanche du dispositif de conversion de l'état de la technique présente un diamètre supérieur à 3m, alors que l'enceinte 14 du dispositif de conversion 10 selon l'invention présente un diamètre inférieur à 2,8m, de préférence égal à 2,6m.

On conçoit ainsi que l'invention permet de proposer un dispositif de conversion d'énergie électrique présentant un encombrement plus faible, tout en offrant une meilleure accessibilité aux équipements électriques du module de puissance.

## Revendications

1. Dispositif (10) de conversion d'énergie électrique pour un système d'entraînement électrique de station sous-marine de compression et de pompage, du type comprenant :
- un module électrique de puissance (12), le module électrique de puissance (12) comportant au moins une poutre (30, 32, 64),
- une enceinte étanche (14) de logement du module de puissance (12), l'enceinte étanche (14) s'étendant selon une direction longitudinale (X),
- une pluralité d'organes (16) de maintien du module électrique (12) à l'intérieur de l'enceinte étanche (14), chaque organe de maintien (16) comportant au moins une liaison mécanique (50, 52), la ou chaque liaison mécanique (50, 52) d'un organe de maintien (16) respectif étant reliée à une unique poutre (30, 32, 64) du module de puissance (12),
**caractérisé en ce que** le nombre P d'organe(s) de maintien (16) disposé(s) sensiblement dans un même plan transversal, perpendiculaire à la direction longitudinale(X), est un nombre entier inférieur ou égal à 2.

2. Dispositif (10) selon la revendication 1, dans lequel le nombre P est égal à 2.

3. Dispositif (10) selon la revendication 2, dans lequel les organes de maintien (16) disposés dans un même plan transversal sont diamétralement opposés par rapport à un axe médian (M) du module (12), l'axe médian (M) étant parallèle à la direction longitudinale (X).

4. Dispositif (10) selon l'une quelconque des revendications précédentes, dans lequel les organes de maintien (16) sont disposés en N positions longitudinales (X1 à X6) successives selon la direction longitudinale (X), N étant un nombre entier supérieur ou égal à 2, de préférence supérieur ou égal à 3, de préférence encore supérieur ou égal à 5.

5. Dispositif (10) selon l'une quelconque des revendications précédentes, dans lequel le module électrique de puissance (12) comprend une ossature mécanique (18) comportant deux longerons (30) sensiblement longitudinaux, et au moins deux traverses (32), chaque traverse (32) reliant mécaniquement les deux longerons (30).

6. Dispositif (10) selon la revendication 5, dans lequel chaque organe de maintien (16) est solidaire d'un longeron (30) respectif.

7. Dispositif (10) selon la revendication 5 ou 6, dans lequel le module électrique de puissance (12) comprend en outre au moins un plateau transversal (34) agencé perpendiculairement aux longerons (30), le ou chaque plateau transversal (34) étant solidaire des deux longerons (30).

8. Dispositif (10) selon la revendication 7, dans lequel les organes de maintien (16) sont fixés au voisinage de chacune des extrémités des longerons (30) et également en regard d'au moins un plateau transversal (34) disposé à l'écart des extrémités des longerons (30).

9. Dispositif (10) selon l'une quelconque des revendications précédentes prise avec la revendication 4, l'enceinte étanche (14) comportant au moins deux tronçons (20, 22) successifs suivant la direction longitudinale (X), dans lequel le ou les organe(s) de maintien (16) disposé(s) en l'une (X1) des deux positions longitudinales extrêmes comporte(nt) des moyens (26) de suspension à un tronçon (20) correspondant.

10. Dispositif (10) selon la revendication 9, dans lequel le ou les organe(s) de maintien (16) disposé(s) en une position longitudinale (X2 à X6) autre que ladite position longitudinale extrême (X1) comporte(nt) des moyens (28) d'appui contre l'enceinte (14).

11. Dispositif (10) selon la revendication 10, dans lequel les moyens d'appui (28) correspondant à un organe de maintien (16) respectif comportent deux ressorts (52), chaque ressort (52) présentant une direction de travail (T1, T2) selon laquelle la force du ressort est supérieure à celle selon les autres directions, et les directions de travail (T1, T2) des deux ressorts (52) sont perpendiculaires.

## Patentansprüche

1. Vorrichtung (10) zum Umrichten von elektrischer Energie für ein elektrisches Antriebssystem einer Unterwasser-Kompressions- und Pumpstation, aufweisend:
- ein elektrisches Leistungsmodul (12), wobei das elektrische Leistungsmodul (12) wenigstens einen Träger (30, 32, 64) aufweist,
- einen abgedichteten Bereich (14) zur Aufnahme des Leistungsmoduls (12), wobei sich der abgedichtete Bereich (14) in einer Längsrichtung (X) erstreckt,
- eine Mehrzahl von Halteeinrichtungen (16) für das elektrische Modul (12) im Inneren des abgedichteten Bereichs (14), wobei jede Halteeinrichtung (16) zumindest ein mechanisches Verbindungsmittel (50, 52) aufweist, wobei das oder jedes Verbindungsmittel (50, 52) einer Halteeinrichtung (16) jeweils mit einem einzigen Träger (30, 32, 64) des Leistungsmoduls (12) verbunden ist,
**dadurch gekennzeichnet, dass** die Anzahl P der Halteeinrichtungen (16), die im Wesentlichen in einer gemeinsamen rechtwinklig zur Längsrichtung (X) ausgerichteten Transversalebene angeordnet sind, eine ganze Zahl kleiner oder gleich 2 ist.

2. Vorrichtung (10) nach Anspruch 1, wobei die Anzahl P gleich 2 ist.

3. Vorrichtung (10) nach Anspruch 2, wobei die in einer gemeinsamen Transversalebene angeordneten Halteeinrichtungen (16) relativ zu einer Mittelachse (M) des Moduls (12) diametral gegenüberliegend angeordnet sind, wobei sich die Mittelachse (M) parallel zur Längsrichtung (X) erstreckt.

4. Vorrichtung (10) nach einem der vorhergehenden Ansprüche, wobei die Halteeinrichtungen (16) in Längsrichtung (X) in N Längspositionen (X1 bis X6) aufeinanderfolgend angeordnet sind, wobei N eine ganze Zahl größer oder gleich 2 ist, vorzugsweise größer oder gleich 3, weiter vorzugsweise größer oder gleich 5.

5. Vorrichtung (10) nach einem der vorhergehenden Ansprüche, wobei das elektrische Leistungsmodul (12) eine Tragkonstruktion (18) aufweist, die zwei im Wesentlichen in Längsrichtung verlaufende Längsträger (30) und mindestens zwei Querträger (32) aufweist, wobei jeder Querträger (32) mechanisch mit den beiden Längsträgern (39) verbunden ist.

6. Vorrichtung (10) nach Anspruch 5, wobei jede Halteeinrichtung (16) fest mit einem jeweiligen Längsträger (30) verbunden ist.

7. Vorrichtung (10) nach Anspruch 5 oder 6, wobei das elektrische Leistungsmodul (12) außerdem mindestens ein Querplateau (24) aufweist, das rechtwinklig zu den Längsträgern (30) angeordnet ist, wobei das oder jedes Querplateau (34) fest mit den beiden Längsträgern (30) verbunden ist.

8. Vorrichtung (10) nach Anspruch 7, wobei Halteeinrichtungen (16) benachbart zu jedem der Enden der Längsträger (30) befestigt und außerdem in Bezug auf das mindestens eine Querplateau (34) mit Abstand zu den Enden der Längsträger (30) angeordnet sind.

9. Vorrichtung (10) nach einem der vorhergehenden Ansprüche und nach Anspruch 4, wobei der abgedichtete Bereich (14) mindestens zwei in Längsrichtung (X) aufeinanderfolgende Abschnitte (20, 22) aufweist, in denen die Halteeinrichtung(en) (16), die in einer (X1) von zwei äußersten Längspositionen angeordnet ist bzw. sind, Federmittel (26) im betreffenden Abschnitt (20) aufweisen.

10. Vorrichtung (10) nach Anspruch 9, wobei die Halteeinrichtung(en) (16), die in einer sich von der genannten äußersten Längsposition (X1) unterscheidenden Längsposition (X2 bis X6) angeordnet ist bzw. sind, Drückmittel (28) gegen den Bereich (14) aufweist.

11. Vorrichtung (10) nach Anspruch 10, wobei die einer jeweiligen Halteeinrichtung (16) zugeordneten Drückmittel (28) zwei Federn (52) aufweisen, wobei jede Feder (52) eine Arbeitsrichtung (T1, T2) beschreibt, in der die Federkraft größer ist als die in den anderen Richtungen und wobei die Arbeitsrichtungen (T1, T2) der beiden Federn (52) rechtwinklig ausgerichtet sind.

## Claims

1. Electrical energy conversion device (10) for a system for electrically driving an underwater compression and pumping station, of the type comprising:
- an electrical power module (12), the electrical power module (12) comprising at least one beam (30, 32, 64),
- a sealed enclosure (14) for housing the power module (12), the sealed enclosure (14) extending in a longitudinal direction (X),
- a plurality of holding members (16) for holding the electrical module (12) inside the sealed enclosure (14), each holding member (16) comprising at least one mechanical connection (50, 52), the or each mechanical connection (50, 52) of a respective holding member (16) being connected to a single beam (30, 32, 64) of the power module (12),
**characterized in that** the number P of holding member(s) (16) arranged substantially in one and the same transverse plane, perpendicular to the longitudinal direction (X), is an integer less than or equal to 2.

2. Device (10) according to Claim 1, in which the number P is equal to 2.

3. Device (10) according to Claim 2, in which the holding members (16) arranged in one and the same transverse plane are diametrically opposed with respect to a median axis (M) of the module (12), the median axis (M) being parallel to the longitudinal direction (X).

4. Device (10) according to any one of the preceding claims, in which the holding members (16) are arranged at N successive longitudinal positions (X1 to X6) in the longitudinal direction (X), N being an integer greater than or equal to 2, preferably greater than or equal to 3, more preferably greater than or equal to 5.

5. Device (10) according to any one of the preceding claims, in which the electrical power module (12) comprises a mechanical framework (18) comprising two substantially longitudinal main beams (30) and at least two cross members (32), each cross member (32) mechanically connecting the two main beams (30).

6. Device (10) according to Claim 5, in which each holding member (16) is secured to a respective main beam (30).

7. Device (10) according to Claim 5 or 6, in which the electrical power module (12) further comprises at least one transverse plate (34) arranged perpendicularly to the main beams (30), the or each transverse plate (34) being secured to the two main beams (30).

8. Device (10) according to Claim 7, in which the holding members (16) are fixed near each of the ends of the main beams (30) and also facing at least one transverse plate (34) positioned away from the ends of the main beams (30).

9. Device (10) according to any one of the preceding claims considered with claim 4, the sealed enclosure (14) comprising at least two successive segments (20, 22) in the longitudinal direction (X), in which the holding member(s) (16) arranged at one (X1) of the two extreme longitudinal positions comprises (comprise) means (26) of suspension from a corresponding segment (20).

10. Device (10) according to Claim 9, in which the holding member(s) (16) arranged at a longitudinal position (X2 to X6) other than the said extreme longitudinal position (X1) comprises (comprise) bearing means (28) for bearing against the enclosure (14).

11. Device (10) according to Claim 10, in which the bearing means (28) corresponding to a respective holding member (16) comprise two springs (52), each spring (52) having a working direction (T1, T2) in which the spring force is greater than the force in the other directions, and the working directions (T1, T2) of the two springs (52) are perpendicular.
